# EUROPEAN PATENT APPLICATION

(11) **EP 1 803 568 A2**
(43) Date of publication of application: **04.07.2007**
(21) Application number: 06023758.3
(22) Date of filing: 15.11.2006
(51) Int. Cl.: B41J 2/175, B41J 2/195, G01N 21/35

(54) **Optical sensor, ink cartridge, and inkjet apparatus**

(30) Priority: 18.11.2005 JP 2005333866
(71) Applicant: SEIKO EPSON CORPORATION, Shinjuku-ku Tokyo 163-0811 (JP)
(72) Inventor: Kondo, Takayuki, Nagano-ken 392-8502 (JP); Hara, Hiroyuki, Nagano-ken 392-8502 (JP); Toyoda, Naoyuki, Nagano-ken 392-8502 (JP); Amano, Kazuhiko, Nagano-ken 392-8502 (JP)
(74) Representative: HOFFMANN EITLE

(57) **Abstract**

An optical sensor (111) for identifying a subject, e.g., an ink (120), including a light absorption member, e.g., an identification marker (121,122), with light absorption characteristics adjusted independently from the subject so that the optical sensor identifies the subject by optically identifying the light absorption member, comprises a light emitting device (113) for radiating reference light having a peak wavelength in an absorption wavelength region of the light absorption member to the subject, a light receiving device (114) for receiving the reference light transmitted through the subject, and an integrated circuit board (115) provided with the light emitting device and the light receiving device on a substrate face.

## Description

### BACKGROUND

### 1. Technical Field

The present invention relates to an optical sensor which can be utilized for identifying ink or the like, and an ink cartridge and an inkjet apparatus which include the optical sensor.

### 2. Related Art

In recent years, inkjet printers have become able to realize print qualities equal to of photographs. In addition, durability of printed matters has been improved. It is needless to say that such improvement results from the fact that mechanical performances of printers have been improved. On the other hand, such improvement largely benefits from the fact that performance and qualities of ink have been improved and color tone control technologies based on characteristics of each ink have been developed.

As such inkjet printers have become widely used, ink with various characteristics has been developed, and various types of ink have been introduced. To assure print qualities in the circumstances that various types of ink exist, it is necessary to identify ink.

As a method of identifying ink, for example, methods disclosed in the following first and second examples of related art have been known. In the first example of related art, light absorption characteristics of ink (color of ink) are identified by sequentially radiating light of R, G, and B toward ink inside the cartridge and comparing reflected light amounts thereof, and thereby whether or not the cartridge is set in the correct position is judged. In the second example of related art, a light receiving device and a light emitting device are arranged in such a manner that a light path traverses an ink flow path of a head, and presence of ink and the ink density are judged from a transmitted light amount of the light.

JP-A-2004-66743 and JP-A-2003-63013 are examples of related art.

In the optical sensors of the first and the second examples of related art, though rough color difference, rough density change or the like can be identified, it is difficult to assure strict ink qualities (print qualities) such as delicate color tone difference. Further, when other ink of the same color as the original ink with constituents different from of the original ink is used, the ink may be clogged in the nozzle hole or the ink may not be successfully discharged. Such problems are not limited to the case that the ink type is identified, but may commonly occur in the case that various subjects are identified.

### SUMMARY

An advantage of some aspects of the invention is to provide an optical sensor which can precisely identify subjects such as ink, and an ink cartridge and an inkjet apparatus which include such an optical sensor.

According to a first aspect of the invention, there is provided an optical sensor for identifying a subject which contains a light absorption member with light absorption characteristics adjusted independently from of the subject, and for identifying the subject by optically identifying the light absorption member. The optical sensor includes a light emitting device for radiating reference light having a peak wavelength in an absorption wavelength region of the light absorption member to the subject, a light receiving device for receiving the reference light transmitted through the subject, and an integrated circuit board provided with the light emitting device and the light receiving device on a substrate face.

In the optical sensor according to the first aspect of the invention, the light absorption member (The light absorption member represents a coloring matter, a dye or the like which absorbs reference light in a certain wavelength. In this specification, the light absorption member may be referred to as "identification marker" to differentiate the light absorption member from a coloring matter or the like contained in ink or the like.) as an identification indicator is contained in the subject. The type or the like of the subject is identified by identifying the light absorption member. Here, the light absorption characteristics of the light absorption member are adjusted independently from the light absorption characteristics of the subject. For example, when the subject is ink used for printing, the light absorption characteristics of the light absorption member are adjusted independently from a color material contained in ink. Such light absorption characteristics include a light absorption peak wavelength, light absorbance and the like, which are different from the light absorption peak wavelength, the light absorbance and the like of a color material or the like contained in the subject. The light absorption characteristics of the light absorption member can be voluntarily controlled by the type and the amount (density) of the light absorption member. Therefore, compared to the existing method of identifying the type or the like of a subject by slight difference of light absorption characteristics of the subject itself, more precise identification is enabled.

In this case, a light absorption peak wavelength of the light absorption member may exist in the infrared region.

According to the above structure, for example, by using a light absorption member which has light absorbance close to 0 in the visible light region and has wavelength absorption characteristics in a state of a peak in the infrared region, the color of the subject may be maintained.

In this case, as the light absorption member, a plurality of light absorption members for absorbing light in a wavelength different from each other may be provided. Further, as the light emitting device, a plurality of light emitting devices having each peak wavelength corresponding to a light absorption peak wavelength of the plurality of light absorption members may be provided. Furthermore, the plurality of light absorption members may be identified based on a light absorbance ratio between the plurality of light absorption members in relation to the reference light or a density ratio between the plurality of light absorption members calculated therefrom, and the subject may be identified based on a result of the identification.

According to the above structure, compared to the case of identifying a light absorption member by using single reference light, accurate identification may be made. That is, when identification is made by using single reference light, light amount change between the reference light before being transmitted through a subject and after the reference light being transmitted through the subject is detected. In this case, the transmitted light amount could be largely changed due to absorption by a container accommodating the subject or the like, and therefore accurate identification could be difficult. Meanwhile, when identification is made based on the light absorbance ratio between the plurality of reference light (ratio between transmitted light amounts), absorption by a container or the like occurs at a similar ratio for all the reference light, and therefore a detection error as light absorbance ratio is not much large. Therefore, when the light absorbance ratio between each light absorption member (that is, density ratio between the light absorption members) is appropriately adjusted, the type or the like of the subject may be accurately identified with almost no detection error.

In this case, the light emitting device may be jointed to the integrated circuit board by a transcription technology.

The light emitting device obtained by such a transcription technology is extremely small (for example, an area of several hundred square µm or less, and a thickness of several ten µm or less). Therefore, an integrated circuit board with a compact structure and a high light emitting function can be realized.

Further, the light emitting device fabricated by the transcription technology is extremely thin. Therefore, for example, a vertical cavity surface emitting laser or a light emitting diode is fabricated as a light emitting device, not only the light on the top face side radiated as reference light, but also the light on the bottom face side radiated to the compound semiconductor layer side can be extracted outside. That is, when a compound semiconductor substrate formed with a light emitting section is directly utilized as a light emitting device without using the transcription technology, a thick compound semiconductor layer (compound semiconductor substrate) exists under an active layer, and therefore even when light is radiated from the active layer to an integrated circuit board side (compound semiconductor layer side), the light is mostly absorbed by the compound semiconductor layer, and is not able to be extracted outside. Therefore, in this case, when light radiated from the light emitting device is monitored and provided with Auto Power Control (APC), a special light receiving optical system for monitoring which performs, for example, reflecting part of the reference light radiated to the top face side (opposite side of the integrated circuit substrate) becomes necessary.

Meanwhile, in the case of the light emitting device fabricated by the transcription technology, the light emitting device is formed by exfoliating the surface section of a compound semiconductor substrate. Therefore, the compound semiconductor layer becomes extremely thin, and the light radiated to the integrated circuit board side is hardly absorbed by the compound semiconductor layer and may be extracted outside.
Therefore, when a light receiving device for monitoring such light is provided on the integrated circuit board side, APC may be easily performed without providing a special light receiving optical system. Furthermore, such light is useless light which should be originally absorbed by the compound semiconductor substrate. Therefore, by utilizing such light as monitor light, light may be utilized effectively.

Further, the substrate used for forming the light emitting device (a compound semiconductor substrate or the like) can be reutilized repeatedly. Therefore, the cost of the light emitting device itself may be sufficiently reduced.

In this case, the light emitting device may be made of a vertical cavity surface emitting laser or a light emitting diode.

According to the above structure, since the wavelength width of radiated light is narrow and the wavelength can be selected accurately, reference light which is favorably suitable may be obtained. In addition, such light is suitable as reference light for measuring light absorption and transmission since spread of radiated light is small and directivity thereof is high. Further, compared to the case using an edge emitting laser as a light emitting device, a more compact structure may be realized.

In this case, a light receiving device for monitoring which monitors the reference light radiated from the light emitting device to the integrated circuit board side may be provided in a section of the integrated circuit board where the light emitting device is jointed.

According to the above structure, light emitted to the integrated circuit board side which does not contribute to a sensor function may be utilized as light for monitoring.

In this case, a current control circuit for controlling a light emitting amount of the light emitting device based on a light amount of light received by the light receiving device for monitoring (monitor light) may be provided on the integrated circuit board.

According to the above structure, the emitted light amount of the light emitting device may be controlled in a desired range regardless of change of the ambient temperatures, time-series change such as deterioration of the device and the like. Further, since the current control circuit is arranged in the vicinity of the light emitting device or the light receiving device, control may be made speedier and more accurately based on the monitor light.

In this case, an amplification circuit for amplifying a signal of light received by the light receiving device for monitoring may be provided on the integrated circuit board.

According to the above structure, an emitted light amount of the light emitting device may be controlled more precisely.

In this case, the plurality of light emitting devices may radiate the reference light to the subject in the time sharing manner.

According to the above structure, the light receiving device may be common to the plurality of light emitting devices. Therefore, the optical sensor may be downsized.

In this case, a memory for storing a transmitted light amount of the reference light received by the light receiving device may be provided on the integrated circuit board.

According to the above structure, each transmitted light amount of each reference light may be easily compared.

In this case, the light receiving device may be directly formed on the integrated circuit board by a semiconductor film forming technology.

According to the above structure, compared to the case that the light receiving device is transcription-arranged by using a transcription technology, a light receiving device with larger area may be formed. Therefore, in the case that a light receiving device is common to a plurality of light emitting devices, reference light may be easily received, and the sensitivity may become favorable.

In this case, the integrated circuit board may be mounted on a printed wiring insulating substrate.

According to the above structure, handling characteristics of the optical sensor may be improved. For example, when the insulating substrate is a flexible film substrate, such film substrate may be wound around a container or the like which accommodates the subject. Thereby, a small optical sensor with a small mounting area may be realized.

In this case, the light emitting device or the light receiving device may be sealed by a resin which transmits the reference light.

According to the above structure, the light emitting device or the light receiving device may be protected from moisture, oxygen or the like, and mechanical strength of the optical sensor may be improved.

According to a second aspect of the invention, an ink cartridge includes the optical sensor according to the first aspect of the invention. In the ink cartridge, the optical sensor identifies ink accommodated in the ink cartridge as the subject.

According to the above structure, an ink cartridge in which the type of ink can be accurately identified and mounting wrong ink in an inkjet apparatus main body can be prevented may be provided.

In this case, the ink cartridge may be made of a member which transmits the reference light radiated from the light emitting device, and the optical sensor may be mounted on an outer wall of the ink cartridge.

According to the above structure, an ink cartridge in which handling the optical sensor is easy and which has a compact structure may be provided.

In this case, a resin having a refractive index equal to of the outer wall may be filled between the outer wall of the ink cartridge and the light emitting device or the light receiving device.

According to the above structure, light loss due to reflection or refraction on the outer wall interface may be reduced.

According to a third aspect of the invention, an inkjet apparatus includes the optical sensor of the first aspect of the invention or the ink cartridge of the second aspect of the invention. In the inkjet apparatus, the optical sensor identifies ink accommodated in the ink cartridge as the subject.

According to the above structure, an inkjet apparatus which can prevent lowering of print quality due to mounting a wrong ink cartridge, damage of the inkjet head due to supplying wrong ink or the like may be provided.

### BRIEF DESCRIPTION OF THE DRAWINGS

The invention will be described with reference to the accompanying drawings, wherein like numbers reference like elements.

Fig. 1 is a perspective view showing a schematic structure of an inkjet apparatus according to a first embodiment.

Fig. 2 is an exploded perspective view showing a main section structure of an ink cartridge provided in the inkjet apparatus.

Fig. 3 is a cross section of an optical sensor provided in the ink cartridge.

Fig. 4 is a cross section showing a main section structure of the optical sensor.

Fig. 5 is a block diagram showing an APC circuit provided on an integrated circuit board of the optical sensor.

Fig. 6 is a block diagram showing a control circuit of the optical sensor.

Figs. 7A, 7B, and 7C are charts for explaining a method of identifying ink by identification markers.

Fig. 8 is a view of a step for explaining a manufacturing method of the optical sensor.

Fig. 9 is a view of a step for explaining the manufacturing method of the optical sensor.

Fig. 10 is a view of a step for explaining the manufacturing method of the optical sensor.

Fig. 11 is a view of a step for explaining the manufacturing method of the optical sensor.

Fig. 12 is a view of a step for explaining the manufacturing method of the optical sensor.

Fig. 13 is a view of a step for explaining the manufacturing method of the optical sensor.

Fig. 14 is a view of a step for explaining the manufacturing method of the optical sensor.

Fig. 15 is a view of a step for explaining the manufacturing method of the optical sensor.

Fig. 16 is a view of a step for explaining the manufacturing method of the optical sensor.

Fig. 17 is a view of a step for explaining the manufacturing method of the optical sensor.

Fig. 18 is a cross section showing more preferable mode of the optical sensor.

Fig. 19 is a cross section showing other mode of the optical sensor.

Fig. 20 is an exploded perspective view showing a main section structure of an ink cartridge according to a second embodiment.

### DESCRIPTION OF EXEMPLARY EMBODIMENTS

Embodiments of the invention will be described with reference to the drawings.

In the following respective drawings, scale sizes of respective layers and respective members are different from each other to show the respective layers and the respective members in proportions recognizable in the drawings.

### First Embodiment

### Inkjet apparatus

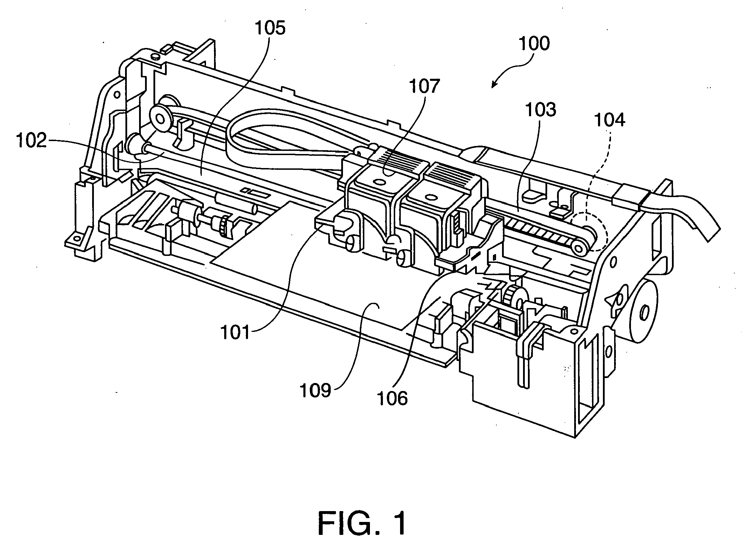

Fig. 1 is a schematic perspective view of an inkjet apparatus including an ink cartridge according to a first embodiment of the invention.

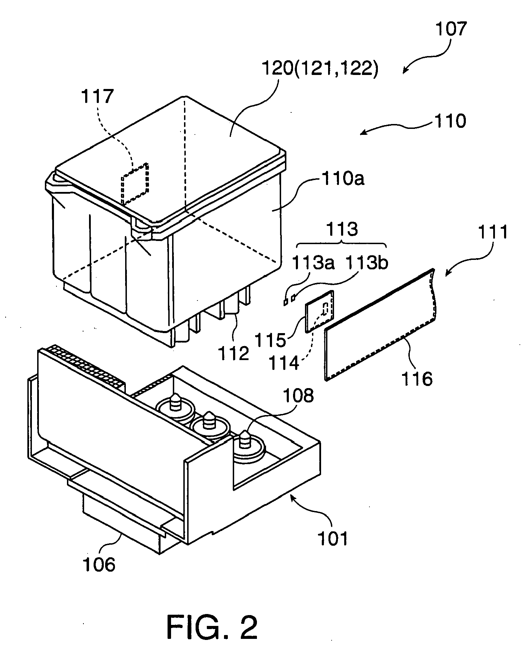

Fig 2 is an exploded perspective view showing a main section of a printing unit including the ink cartridge.

As shown in Fig. 1, an inkjet apparatus 100 includes a carriage 101 mounting an ink cartridge and an inkjet recording head 106.

The carriage 101 supported by a guide member 102 is connected to a step motor 104 through a timing belt 103, and can be reciprocated in parallel with a platen 105. The inkjet recording head 106 is mounted on the bottom face of the carriage 101. A printing unit 107 is removably mounted on the top face of the carriage 101.

As shown in Fig. 2, the printing unit 107 includes an ink cartridge 110 and the carriage 101 mounting the ink cartridge 110.

The carriage 101 is formed of an open-top box. The inkjet recording head 106 (hereinafter simply referred to as head) is provided on the bottom face of the carriage 101 which is opposed to a recording sheet 109 (refer to Fig. 1). A plurality of ink supply styluses 108 are provided in the section of the head 106 which is opposed to a supply port 112 on the bottom face of the ink cartridge 110. The ink supply styluses 108 are inserted in the supply port 112 and receive ink supply from the ink cartridge 110. The ink supplied to the ink supply styluses 108 is guided to a nozzle (not shown) of the head 106 through an unshown filter.

An optical sensor 111 for identifying ink inside the ink cartridge 110 is mounted on an outer wall 110a of the ink cartridge 110.

The optical sensor 111 has a light emitting device 113 for radiating reference light to ink 120 inside the ink cartridge 110, a light receiving device 114 for receiving the reference light transmitted through the ink 120 inside the ink cartridge 110, an integrated circuit board 115 electrically connected to the light emitting device 113 and the light receiving device 114, and a printed wiring board 116 electrically connected to the integrated circuit board 115.

The optical sensor 111 identifies the type or the like of the ink 120 by radiating reference light to the ink 120 accommodated in the ink cartridge 110 and measuring light absorbance thereof. In particular, the optical sensor 111 is characterized in that the optical sensor 111 identifies the type or the like of the ink 120 by using light having peak wavelengths corresponding to absorption wavelengths of identification markers 121 and 122 contained in the ink as reference light, and optically identifying the identification markers 121 and 122.

Here, the identification marker means a light absorption member such as a coloring matter and a dye which shows light absorbance for light in a specific wavelength (reference light). The light absorption characteristics of the identification marker is adjusted independently from the light absorption characteristics of the ink 120, which is a subject, that is, light absorption characteristics of a color material contained in a solvent of the ink or the ink. The light absorption characteristics includes a light absorption peak wavelength, light absorbance and the like, which are different from the light absorption peak wavelength, the light absorbance and the like of the color material or the like contained in the ink 120. The light absorption characteristics of the identification marker can be voluntarily controlled by the type and the amount (density) of the identification marker.

As such an identification marker, a light absorption member with wavelength light absorption characteristics that the light absorbance is close to 0 in the visible light region so that color of the ink 120 is not impaired, and the peak is shown in the infrared region, is suitable. The ink 120 inside the ink cartridge 110 contains a plurality of (2 types in this embodiment) identification markers 121 and 122 with a light absorption peak wavelength different from each other.

The light emitting device 113 includes a plurality of light emitting devices 113a and 113b which radiate reference light in a wavelength different from each other according to multiple types of identification markers contained in the ink. As the light emitting devices 113a and 113b, a vertical cavity surface emitting laser is suitable. In particular, since in the vertical cavity surface emitting laser, a wavelength width of radiated light is narrow and the wavelength can be selected accurately, the vertical cavity surface emitting laser is highly suitable as reference light. In addition, the vertical cavity surface emitting laser is suitable as reference light for measuring light absorption and transmission since spread of radiated light thereof is small and directivity thereof is high.
Further, compared to the case of using an edge emitting laser as a light emitting device, the vertical cavity surface emitting laser can realize a more compact structure. However, it is possible to use a light emitting diode instead of the vertical cavity surface emitting laser.

The light emitting devices 113a and 113b are semiconductor devices formed of a minute tile (minute tile-shaped device). For example, the light emitting devices 113a and 113b are a quadrangular platy member being 1 µm to 20 µm thick and being several ten µm to several hundred µm long vertically and horizontally. The light emitting devices 113a and 113b are adhered to the top face of the integrated circuit board 115 made of a silicon substrate or the like, that is, to the face which is a surface of the integrated circuit board 115 opposed to the outer wall of the ink cartridge 110. The light emitting devices 113a and 113b are jointed to the integrated circuit board 115 by using a transcription technology called Surface Free Technology by Laser Ablation (SUFTLA, registered trademark)..

As the light emitting devices 113a and 113b, a device having a peak wavelength corresponding to a light absorption peak wavelength of each corresponding identification marker is selected. For example, the first light emitting device 113a radiates reference light in 814 nm which is a light absorption peak wavelength of a first identification marker mixed in the ink (first wavelength). Meanwhile, the second light emitting device 113b radiates reference light in 870 nm which is a light absorption peak wavelength of a second identification marker (second wavelength). Here, the first light emitting device 113a which radiates the reference light in 814 nm can be fabricated by using, for example, GaAs quantum well as an active layer of a vertical cavity surface emitting laser. Further, the second light emitting device 113b which radiates the reference light in 870 nm can be fabricated by using a GaAs layer as an active layer of a vertical cavity surface emitting laser.

As another example, it is possible to use reference light in 850 nm as the first wavelength and reference light in 970 nm as the second wavelength. In this case, the first light emitting device 113a which radiates the reference light in 850 nm can be fabricated by using GaAs quantum well as an active layer of a vertical cavity surface emitting laser. Further, the second light emitting device 113b which radiates the reference light in 970 nm can be fabricated by using InGaAs quantum well as an active layer of a vertical cavity surface emitting laser.

The optical sensor 111 identifies the type or the like of the ink 120 by radiating the plurality of reference light in different peak wavelengths as above to the ink 120 inside the ink cartridge 110 through the outer wall of the ink cartridge 110 and comparing the intensity (that is, light absorbance) of the reference light transmitted through the ink 120 to each other. When such an identification method is adopted, the light absorption characteristics of the identification markers 121 and 122 are voluntarily controlled by the type and the amount of the identification markers 121 and 122. Therefore, compared to the existing method in which the type or the like of the ink 120 is identified by a slight difference of the light absorption characteristics of the ink itself, more precise identification is enabled. Further, by accurately identifying the type of the ink 120, that is, the characteristics of the ink 120, color tone control corresponding to such identification is enabled, and the print quality can be assured. Further, when the ink cartridge 110 is wrongly mounted, users can be notified. Furthermore, the state that ink inside the ink cartridge 110 becomes vacant can be detected by change of the transmitted light amount.

The optical sensor 111 is mounted on the outer wall of the ink cartridge 110. Therefore, as a material for the outer wall of the ink cartridge 110, a material which sufficiently transmits reference light radiated from the light emitting device 113 is used. A mounting position of the optical sensor 111 can be selected as appropriate according to the shape of the ink cartridge 110 so that detecting ink end can be easily made and the remaining ink amount when detecting ink end is small as much as possible. For example, the mounting position of the optical sensor 111 is preferably in the vicinity of the bottom face of the ink cartridge 110, in the vicinity of an ink outlet, or in the middle of the final flow path connected to the ink outlet.

The light receiving device 114 is a light receiving device common to the light emitting device 113a and the light emitting device 113b. For example, reference light radiated from the light emitting device 113a and the light emitting device 113b alternately enters the light receiving device 114 in the time-sharing manner. As the light receiving device 114, a photodiode is suitable, but a phototransistor can be used as well.

Further, the light receiving device 114 is desirably formed directly on the integrated circuit board 115 by a semiconductor film forming technology. In the case of the light receiving device, a light receiving device with a sufficient performance can be formed on the silicon substrate. Therefore, it is not necessary to make transcription-arrangement by using a transcription technology as in the light emitting device. By directly forming the light receiving device on the integrated circuit board 115, a light receiving device with a larger area than in the case of using a transcription technology such as SUFTLA can be formed. In particular, in this embodiment, the light receiving device is common to the plurality of light emitting devices. Therefore, by forming the light receiving device with a large area, reference light is easily received, and the sensitivity becomes favorable. However, it is possible that the light receiving device is transcription-arranged on the integrated circuit board 115 by a transcription technology.

In this embodiment, the light receiving device 114 and the light emitting devices 113a and 113b are arranged side by side on the same face which is the outer wall 110a of the ink cartridge. Therefore, a light reflector 117 which reflects light radiated from the light emitting devices 113a and 113b to the light receiving device 114 side is provided on an inner wall 110b of the ink cartridge 110 which is opposed to the outer wall 110a. That is, reference light radiated from the light emitting devices 113a and 113b is guided to the light receiving device 114 via the outer wall 110a of the ink cartridge 110, the ink 120, the light reflector 117, the ink 120, and the outer wall 110a. When the outer wall of the ink cartridge 110 is made of a material which sufficiently transmits the reference light, the light reflector 117 can be arranged on the outer wall of the ink cartridge 110.

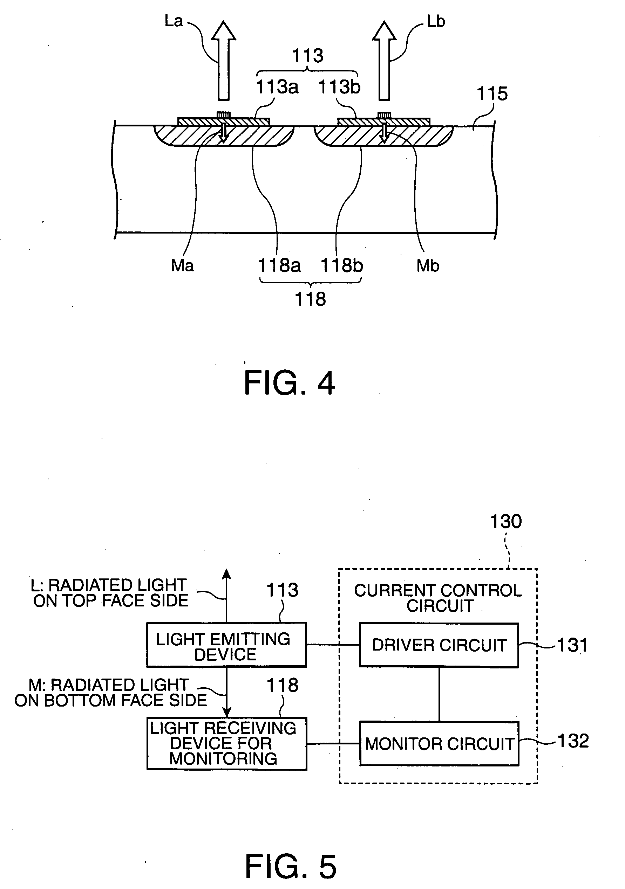

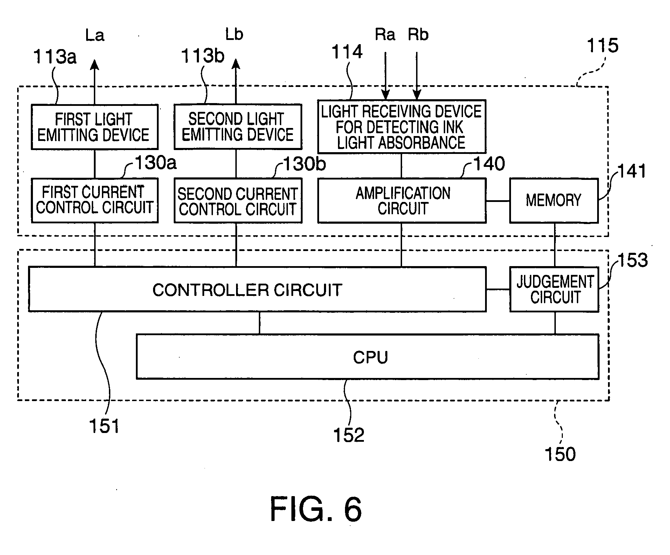

The integrated circuit board 115 is a board in which an integrated circuit having at least one function of a light receiving device for detecting ink light absorbance, a current control circuit, an amplification circuit, a judgement circuit, an I/O circuit, a nonvolatile memory and the like is formed on a silicon substrate. The integrated circuit board 115 may be a board in which a Thin Film Transistor (TFT) or the like is formed on a substrate such as a glass substrate and a plastic substrate instead of a silicon substrate. In this embodiment, the integrated circuit board 115 mounts the light receiving device 114 for detecting ink light absorbance, a current control circuit, an amplification circuit, an I/O circuit, a nonvolatile memory, and a controller circuit for comprehensively controlling the above circuits (refer to Fig. 5 and Fig. 6). Further, by adhering the light emitting devices 113a and 113b to a desired position of the surface of the integrated circuit board 115, the light emitting devices 113a and 113b, the light receiving device 114, and the integrated circuit which structure the optical sensor 111 are united.

The integrated circuit board 115 is mounted on the printed wiring board 116 which is a printed wiring insulating substrate. As the printed wiring board 116, a glass epoxy substrate, a Flexible Printed Circuit (FPC), plastic, glass or the like can be used. The glass epoxy substrate is suitably used since the glass epoxy substrate is easily handled and is not expensive. Examples of the FPC include a polyimide film, a glass cloth, and an aramid film, which are all thin and flexible, and thus are easily bent. Therefore, such a FPC can be wound around the outer wall of the ink cartridge 110.

The printed wiring board 116 is mounted on the outer wall of the ink cartridge 110. The printed wiring board 116 is provided with an electrical contact which is electrically connected to a control circuit 150 (refer to Fig. 6) which is mounted on the inkjet apparatus main body when the ink cartridge 110 is mounted on the inkjet apparatus main body. The printed wiring substrate 116 can be powered from the inkjet apparatus main body or can provide and receive information through the electrical contact.

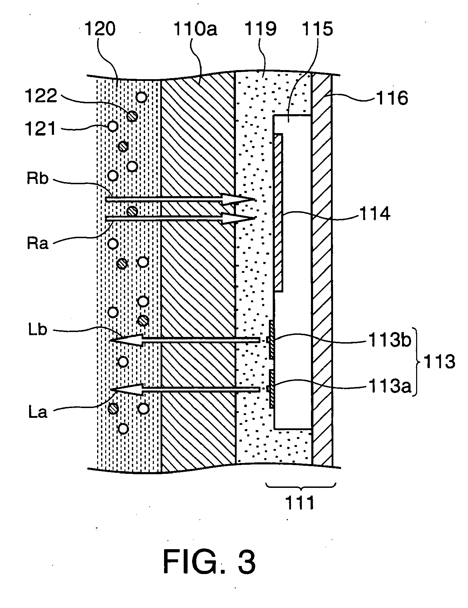

Fig. 3 is a view showing an enlarged joint section between the printed wiring board 116 and the ink cartridge 110.

As shown in Fig. 3, the printed wiring board 116 is mounted on the outer wall of the ink cartridge 110 in such a manner that the light emitting device 113 and the light receiving device 114 are opposed to the ink cartridge 110 side. A resin 119 having a refractive index equal to of the outer wall 110a is filled between the outer wall 110a of the ink cartridge 110 and the light emitting devices 113a, 113b, and the light receiving device 114. Thereby, light loss due to reflection and refraction on the outer wall interface can be decreased.

Fig. 4 is a view showing an enlarged joint section between the integrated circuit board 115 and the light emitting devices 113a and 113b.

As shown in Fig. 4, light receiving devices for monitoring 118a and 118b which monitor light amounts of light radiated from the light emitting devices 113a and 113b to the integrated circuit board 115 side are provided in the section of the integrated circuit board 115 where the two light emitting devices 113a and 113b are jointed. As the light receiving devices for monitoring 118a and 118b, a photodiode, a phototransistor or the like can be used. For example, the light receiving devices for monitoring 118a and 118b can be formed on the integrated circuit board 115 by, for example, the steps common to of the light receiving device 114 for detecting ink light absorbance (hereinafter referred to as light receiving device for detecting ink light absorbance). In this embodiment, the light emitting devices 113a and 113b are adhered on the light receiving devices for monitoring 118a and 118b provided on the integrated circuit board 115.

A vertical cavity surface emitting laser or a light emitting diode as the light emitting devices 113a and 113b radiates light in the top face direction (in the opposite direction of the integrated circuit board 115). The vertical cavity surface emitting laser or the light emitting diode concurrently radiates light with intensity proportional to a light amount of the foregoing light in the bottom face direction (in the direction of the integrated circuit board 115). The intensity ratio between light La and Lb radiated in the top face direction and light Ma and Mb radiated in the bottom face direction is constant independently from the intensity, and a value thereof is determined by the structure design of the light emitting devices 113a and 113b. Therefore, when the intensity of the light Ma and Mb in the bottom face direction is measured at the light receiving devices for monitoring 118a and 118b, the intensity of the reference light La and Lb radiated in the top face direction can be found. By utilizing such a principle, Auto Power Control (APC) can be performed.

Fig. 5 is a block diagram for explaining the APC by a current control circuit 130.

In Fig. 5, the light emitting device 113a is not particularly differentiated from the light emitting device 113b, and the both are referred to as the light emitting device 113. Similarly, both the light receiving device for monitoring 118a and the light receiving device for monitoring 118b are referred to as the light receiving device for monitoring 118. Further, light radiated in the top face direction (reference light) La and Lb is referred to as radiated light on the top face side L, and light radiated in the bottom face direction (monitor light) Ma and Mb is referred to as radiated light on the bottom face side M.

As described above, in the light emitting device 113, the light M is also radiated in the bottom face direction, and the light M enters the light receiving device for monitoring 118. A current proportional to the light output of the light emitting device 113 flows in the light receiving device for monitoring 118. A monitor circuit 132 outputs an output control signal corresponding to a size of the current flowing in the light receiving device for monitoring 118 to a driver circuit 131. Here, the monitor circuit 132 compares a given reference value to the size of the current flowing in the light receiving device for monitoring 118, and generates the output control signal so that the current becomes a desired certain value, that is, so that the light output of the light emitting device 113 becomes a desired certain value. The driver circuit 131 drives the light emitting device 113 so that light output corresponds to the output control signal. Thereby, the light output of the light emitting device 113 can be kept at a desired certain value regardless of change of the ambient temperatures, time-series change and the like.

Next, a method of identifying ink by using the optical sensor 111 will be described with reference to Fig. 2 and Fig. 6.

Fig. 6 is a block diagram for explaining the method of identifying ink.

In Fig. 6, a current control circuit for performing current control for the light emitting device 113a (first light emitting device) is referred to as a first current control circuit 130a, and a current control circuit for performing current control for the light emitting device 113b (second light emitting device) is referred to as a second current control circuit 130b.

In the inkjet apparatus 100, after the ink cartridge is mounted, or when an apparatus is started, or as a regular operation, a command of sensing is inputted from a CPU 152 of the inkjet apparatus main body to a controller circuit 151.

First, the controller circuit 151 to which the sensing command has been inputted activates an amplification circuit 140 connected to the light receiving device 114 for detecting ink light absorbance.

Subsequently, the controller circuit 151 activates the first current control circuit 130a to make the first light emitting device 113a emit light. Thereby, the reference light La is radiated from the first light emitting device 113a to the ink 120 inside the ink cartridge 110 through the outer wall of the ink cartridge 110.

Here, the peak wavelength of the reference light La approximately corresponds with the light absorption peak wavelength of the first identification marker 121 mixed in the ink 120. The reference light La radiated to the ink 120 is dimmed at a ratio corresponding to the density of the first identification marker 121, and only reference light Ra at a given ratio is inputted to the light receiving device 114 for detecting ink light absorbance. In the light receiving device 114 for detecting ink light absorbance, a current corresponding to a received light amount (first received light amount) of the reference light Ra is flown, which is detected as a monitor signal (first monitor signal).

The first received light amount detected at the light receiving device 114 for detecting ink light absorbance is stored in a nonvolatile memory 141 electrically connected to a judgement circuit 153.

After the foregoing steps are finished, the controller circuit 151 stops the first current control circuit 130a.

Next, the controller circuit 151 activates the second current control circuit 130b to make the second light emitting device 113b emit light. Thereby, the reference light Lb is radiated from the second light emitting device 113b to the ink 120 inside the ink cartridge 110 through the outer wall of the ink cartridge 110.

Here, the peak wavelength of the reference light Lb approximately corresponds with the light absorption peak wavelength of the second identification marker 122 mixed in the ink 120. The reference light Lb radiated to the ink 120 is dimmed at a ratio corresponding to the density of the second identification marker 122, and only reference light Rb at a given ratio is inputted to the light receiving device 114 for detecting ink light absorbance. In the light receiving device 114for detecting ink light absorbance, a current corresponding to a received light amount (second received light amount) of the reference light Rb is flown, which is detected as a monitor signal (second monitor signal).

The second received light amount detected at the light receiving device 114 for detecting ink light absorbance is stored in the nonvolatile memory 141 electrically connected to the judgement circuit 153.

After the foregoing steps are finished, the controller circuit 151 stops the second current control circuit 130b.

After transmitted light amounts of the reference light La and Lb are measured as above, the judgement circuit 153 compares the transmitted light amount of La to the transmitted light amount of Lb (compares the first received light amount to the second received light amount), and detects the type of the ink 120, the remaining amount of the ink 120 and the like.

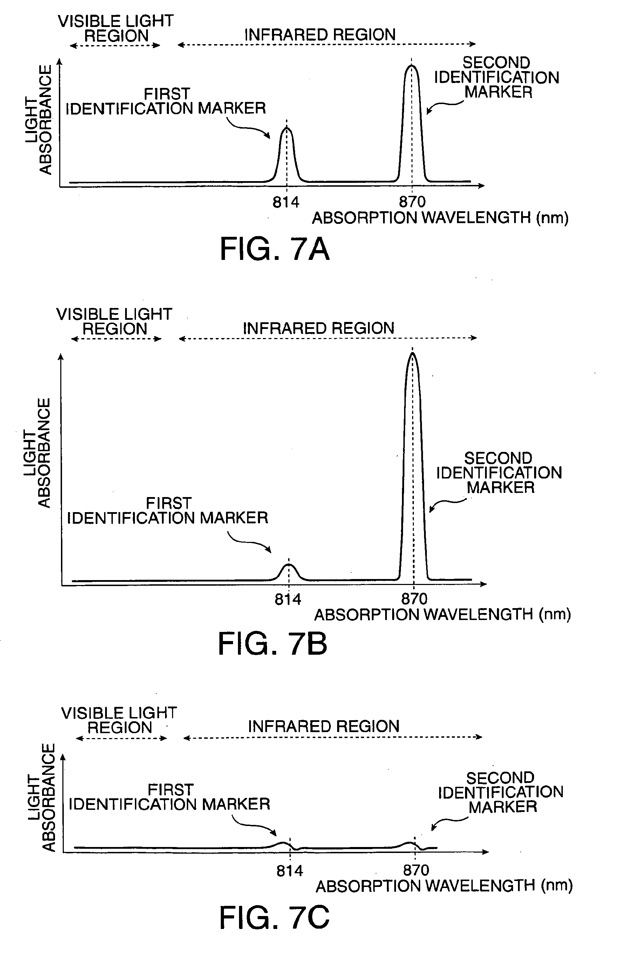

Figs. 7A, 7B, and 7C are charts for explaining a method of detecting a type of ink and a remaining amount of ink.

As shown in Figs. 7A, 7B, and 7C, the first identification marker 121 and the second identification marker 122 have a light absorption peak wavelength in the wavelength region different from each other. In the examples of Figs. 7A, 7B, and 7C, the light absorption peak wavelength of the first identification marker 121 is 814 nm which is the peak wavelength of the reference light La, and the light absorption peak wavelength of the second identification marker 122 is 870 nm which is the peak wavelength of the reference light Lb.

In the judgement circuit 153, the light absorbance of the reference light La and the reference light Lb in the light absorption peak wavelengths (814 nm and 870 nm) is measured and the light absorbance ratio or the density ratio therefrom calculated between the first identification marker 121 and the second identification marker 122 is calculated. Calculated results are compared to a lookup table stored in the nonvolatile memory 141 to identify the type of the ink 120.

For example, in the example of Fig. 7A, the light absorbance ratio between the first identification marker 121 and the second identification marker 122 is approximately 1:2. In the example of Fig. 7B, the light absorbance ratio between the first identification marker 121 and the second identification marker 122 is approximately 1:10. In the lookup table, the absorbance ratio or the density ratio therefrom calculated between the first identification marker 121 and the second identification marker 122 and the type of the ink 120 are stored in such a manner that such a ratio and the type of the ink 120 are shown correspondingly to each other. By comparing the information of the lookup table to the information of the measured received light amounts, the type of the ink 120 can be accurately identified.

The type of ink means a type of ink based on various characteristics of the ink 120 such as a color, a constituent, a manufacturing date, and a sell-by date. For example, the light absorbance ratio between the first identification marker 121 and the second identification marker 122 is specified as 1:2, 1:3, 1:4 and so on according to ink colors, that is, red ink, blue ink, green ink and so on. According to the specified ratio, the identification markers 121 and 122 at a given density are mixed in the ink 120. Otherwise, the light absorbance ratio between the first identification marker 121 and the second identification marker 122 can be specified as 1:2, 1:3 and so on according to the constituent type of ink, that is, pigment ink, dye ink and so on. In the lookup table, such information on the types of the ink 120 and such information on the light absorbance ratio and the like of the identification markers 121 and 122 are shown correspondingly in relation to one for one. However, in reality, there are other factors such as light absorption characteristics on the outer wall of the ink cartridge 110 and the reflection loss at the light reflector 117 and the like. Therefore, by considering the transmission loss of the reference light La and Lb, the light absorbance ratio and the like are calculated.

In this embodiment, one type of information (for example, color of ink) is obtained by using two types of the identification markers 121 and 122. However, it is possible that three or more types of identification markers are used, and thereby a plurality types of information (for example, color of ink and constitution of ink) are concurrently detected. For example, in the case that three types of identification markers are used, it is possible that the color of the ink 120 is identified from the light absorbance ratio between the first identification marker and the second identification marker, and the constituent of the ink 120 is identified from the light absorbance ratio between the first identification marker and the third identification marker.

Next, in the example of Fig. 7C, the light absorbance ratio between the first identification marker 121 and the second identification marker 122 is approximately 1:1. Each light absorbance is almost 0. It means that the reference light La and Lb is hardly absorbed by the ink 120, that is, the remaining amount of the ink 120 on the light path of the reference light La and Lb is extremely small. Therefore, by detecting the light absorbance ratio or an absolute value of the light absorbance as above, information on the remaining amount of the ink 120 can be also obtained.

Descriptions will be given with reference to Fig. 6 again. After information such as the type of ink and the remaining amount of ink is detected as above, the judgement circuit 153 outputs a result of the detected information (result of the type of ink, the ink end signal or the like) to the CPU 152 of the inkjet apparatus main body. In the inkjet apparatus 100, when the ink 120 accommodated in the ink cartridge 110 is ink which does not adapt to the inkjet apparatus 100, a notice such as a message is issued to users. For example, when the color of the ink 120 set in the cartridge holder is different from the originally planned color of ink, users are prompted to set the ink cartridge 110 in the cartridge holder suitable for the color of the ink cartridge 110. When the constituent of the ink 120 is different from the originally planned constituent of ink in the inkjet apparatus 100, users are prompted to set the ink cartridge 110 in which correct ink is accommodated. When the remaining amount of the ink 120 in the ink cartridge becomes small, users are prompted to replace the ink cartridge 110 with a new ink cartridge 110.

### Manufacturing method of the optical sensor

Next, a manufacturing method of the optical sensor 111 will be described.

In the manufacturing method, descriptions will be given of the case that a compound semiconductor device is used as the light emitting devices 113a and 113b, which is jointed to a silicon LSI chip which is to become the integrated circuit board 115. However, the type of the semiconductor device and the type of the LSI chip are not necessarily limited thereto. "Semiconductor substrate" in this embodiment means an object made of a semiconductor material. However, the semiconductor substrate is not limited to a platy substrate. "Semiconductor substrate" includes substrates formed of any shape as long as the substrate is made of a semiconductor material. Further, the light emitting devices 113a and 113b are referred to as the light emitting device (or minute tile-shaped device) 113, and the light receiving devices for monitoring 118a and 118b are referred to as the light receiving device for monitoring 118, except for the case where these elements are particularly distinguished.

### Step 1

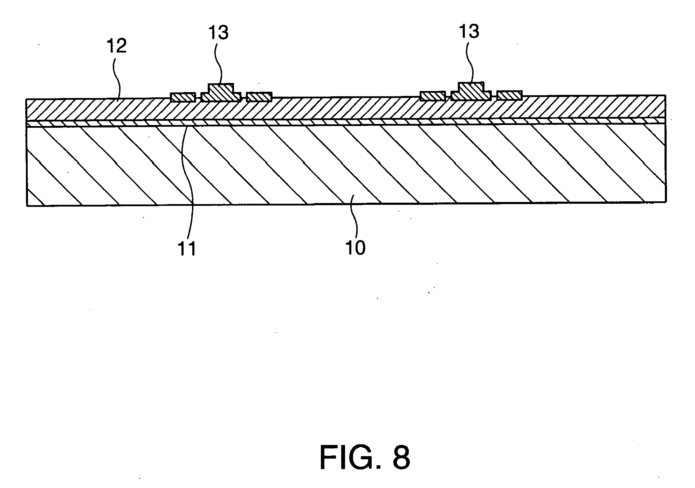

Fig. 8 is a schematic cross section showing step 1 of the manufacturing method of the optical sensor 111.

In Fig. 8, a substrate 10 is a semiconductor substrate such as a gallium arsenic compound semiconductor substrate. A sacrifice 11 is provided as the lowermost layer in the substrate 10. The sacrifice layer 11 is made of aluminum arsenic (AlAs), and is, for example, several hundred nm thick.

For example, a function layer 12 is provided as an upper layer of the sacrifice layer 11. The function layer 12 is, for example, about 1 µm to 20 µm thick. A function section 13 is formed in the function layer 12. The function section 13 structures an operation section of the light emitting devices 113a and 113b. As the function section 13, for example, a light emitting diode (LED), a vertical cavity surface emitting laser (VCSEL), a photodiode (PD), a high electron mobility transistor (HEMT), a hetero bipolar transistor (HBT) and the like can be cited. Each function section 13 is a device formed by layering multiple epitaxial layers on the substrate 10. In each function section 13, an electrode is formed, and operation test is performed as well.

### Step 2

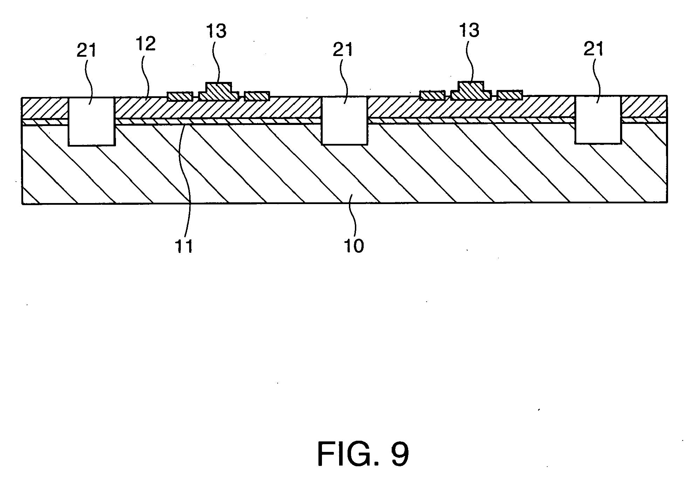

Fig. 9 is a schematic cross section showing step 2 of the manufacturing method of the optical sensor 111.

In this step, a separating groove 21 is formed to separate each function section 13 from each other. The separating groove 21 shall be a groove with a depth at least reaching the sacrifice layer 11. For example, both the width and the depth of the separating groove shall be 10 µm to several hundred µm. Further, the separating groove 21 shall be a continuous groove with no dead end so that an after-mentioned selective etching solution flows through the separating groove 21. Furthermore, the separating groove 21 is preferably formed in a state of a grid.

Further, by setting the distance between each separating groove 21 to several ten µm to several hundred µm, each function section 13 which is separated and formed by the separating groove 21 shall have an area of several ten to several hundred square µm. As a method of forming the separating groove 21, a method by photolithography and wet etching, or a method by dry etching is used. Further, the separating groove 21 may be formed by U-shaped groove dicing in the range where no crack is generated in the substrate.

In forming the separating groove 21, a sulfuric acid etching solution can be used for wet etching, and chlorine gas can be used for dry etching. Since the separating groove 21 has large pattern dimensions and is not necessarily formed precisely, the etching mask does not have to be a photolithography. For example, as an etching mask, offset lithography can be used. Further, in forming the separating groove 21, an orientation of the separating groove 21 in relation to a crystal orientation of the substrate 10 is important.

### Step 3

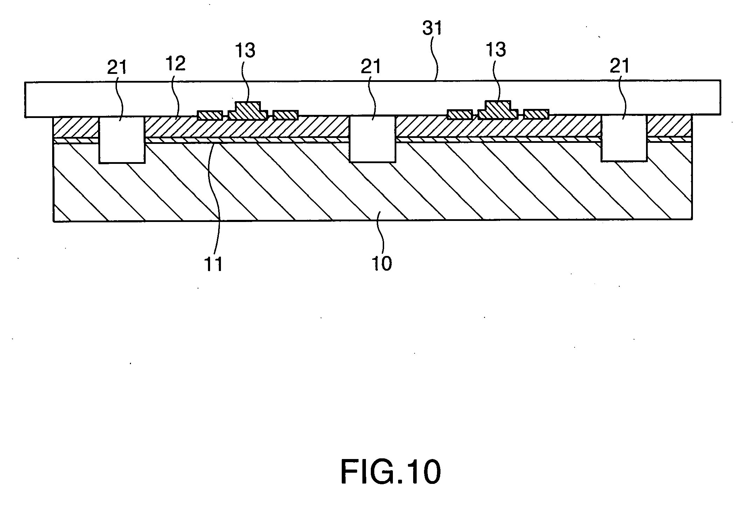

Fig. 10 is a schematic cross section showing step 3 of the manufacturing method of the optical sensor 111.

In this step, an intermediate transcription film 31 is adhered to the surface of the substrate 10 (function section 13 side). The intermediate transcription film 31 is a flexible strip-shaped film with the surface coated with an adhesive.

### Step 4

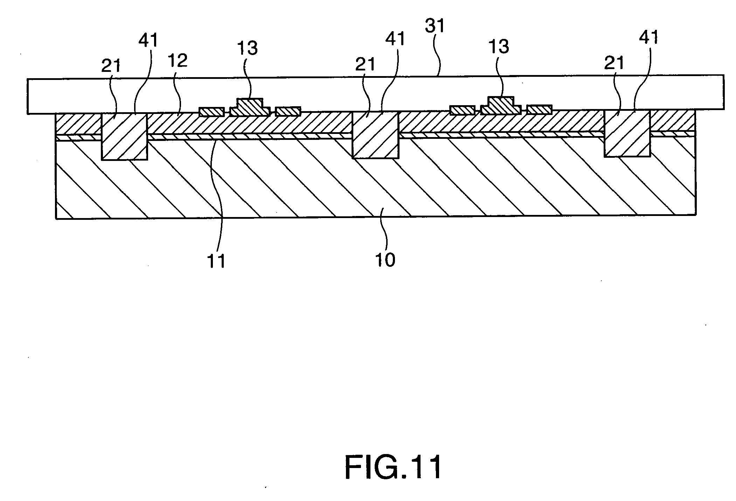

Fig. 11 is a schematic cross section showing step 4 of the manufacturing method of the optical sensor 111.

In this step, a selective etching solution 41 is injected in the separating groove 21. In this step, only the sacrifice layer 11 is selectively etched. Therefore, as the selective etching solution 41, a dilute hydrochloric acid which is highly selective for aluminum arsenic is used. As the selective etching solution 41, dilute hydrofluoric acid can be also used. However, hydrochloric acid is more desirably used in view of selectivity.

### Step 5

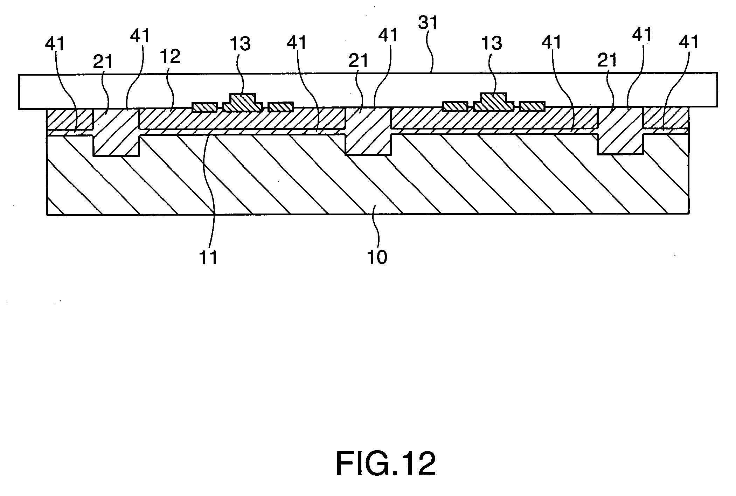

Fig. 12 is a schematic cross section showing step 5 of the manufacturing method of the optical sensor 111.

In this step, after the selective etching solution 41 is injected in the separating groove 21 in step 4 and then a given time lapses, all the sacrifice layer 11 is selectively etched and removed from the substrate 10. After that, pure water is injected in the separating groove 21 and in the region where the sacrifice layer has existed, which are rinsed with the pure water.

### Step 6

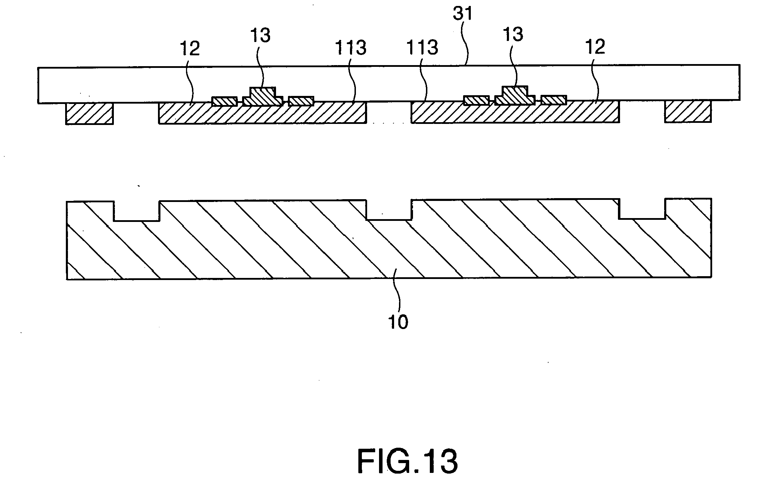

Fig. 13 is a schematic cross section showing step 6 of the manufacturing method of the optical sensor 111.

When the entire sacrifice layer 11 is etched in step 5, the function layer 12 is detached from the substrate 10. In this step, by secluding the intermediate transcription film 31 from the substrate 10, the function layer 12 adhered to the intermediate transcription film 31 is secluded from the substrate 10.

Thereby, the function layer 12 formed with the function section 13 is separated by forming the separating groove 21 and etching the sacrifice layer 11, formed into a semiconductor device in a given shape (for example, minute tile shape) (hereinafter referred to as "minute tile-shaped device 113), and held on the intermediate transcription film 31 by being adhered thereto. Here, the thickness of the function layer is preferably, for example, 1 µm to 8 µm, and the size (length and width) thereof is preferably, for example, several ten µm to several hundred µm. The minute tile-shaped device 113 herein formed is applied to the light emitting devices 113a and 113b.

Further, the substrate 10 detached from the function layer 12 can be reutilized for forming the function section. When a plurality of sacrifice layers 11 are previously provided, the foregoing steps 1 to 6 can be repeatedly performed. By reutilizing the substrate 10, the "minute tile-shaped device 113" can be repeatedly fabricated.

### Step 7

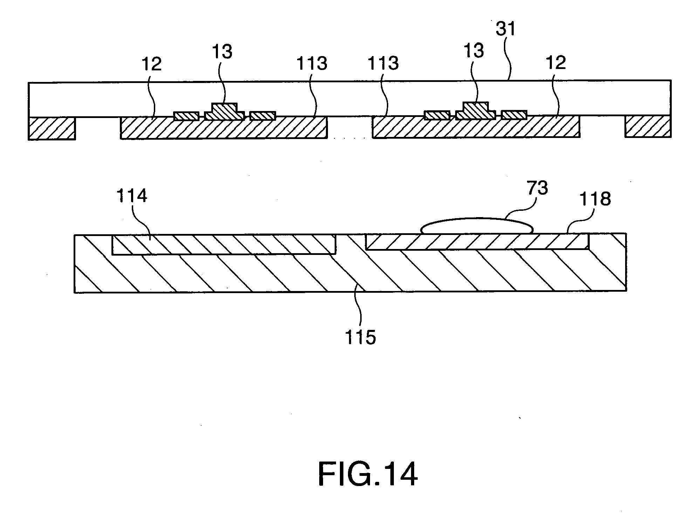

Fig. 14 is a schematic cross section showing step 7 of the manufacturing method of the optical sensor 111.

In this step, by moving the intermediate transcription film 31 to which the minute tile-shaped device 113 is adhered, the minute tile-shaped device 113 is aligned in a desired position of the final substrate 115. Here, the final substrate 115 is made of a silicon semiconductor. The surface of the substrate is formed with the light receiving device 114 for detecting ink light absorbance and the light receiving device for monitoring 118. A desired position of the final substrate 115 is coated with an adhesive 73 for adhering the minute tile-shaped device 113. A section to which the minute tile-shaped device 113 is to be jointed, that is, a section on which the light receiving device for monitoring 118 is formed is coated with the adhesive 73. In Fig. 14, only one light receiving device for monitoring 118 is shown. However, in reality, the light receiving device 118 is formed in each position on which the light emitting device 113a and the light emitting device 113b are mounted.

### Step 8

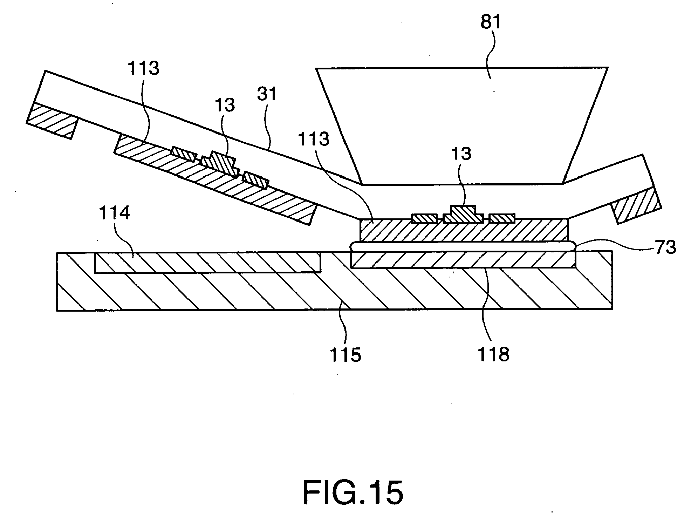

Fig. 15 is a schematic cross section showing step 8 of the manufacturing method of the optical sensor 111.

In this step, the minute tile-shaped device 113 aligned in a desired position of the final substrate 115 is pressed by a rear pressing pin 81 with the intermediate transcription film 31 in between and thereby jointed to the final substrate 115. Here, the desired position is coated with the adhesive 73. Therefore, the minute tile-shaped device 113 is adhered to the desired position of the final substrate 115.

In this step, as a method of adhering the minute tile-shaped device 113 to the final substrate 115, adhesive is used. However, other adhesion method may be used.

### Step 9

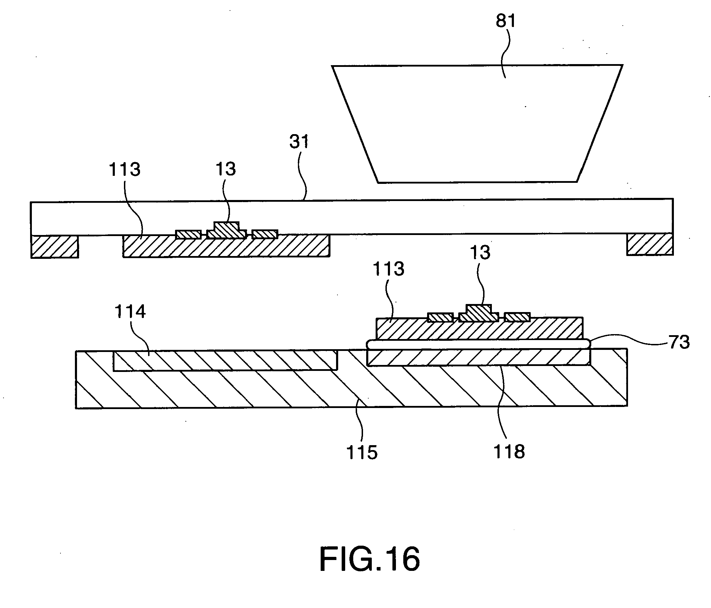

Fig. 16 is a schematic cross section showing step 9 of the manufacturing method of the optical sensor 111.

In this step, adhesive force of the intermediate transcription film 31 is diminished to exfoliate the intermediate transcription film 31 from the minute tile-shaped device 113.

The adhesive used for the intermediate transcription film 31 shall be a UV cure adhesive or a heat curable adhesive. When the UV cure adhesive is used, the rear pressing pin 81 is made of a transparent material. By radiating ultraviolet (UV) from the end of the rear pressing pin 81, the adhesive force of the intermediate transcription film 31 is diminished. When the heat curable adhesive is used, the rear pressing pin 81 is heated. Otherwise, after step 6, for example, by radiating ultraviolet over the intermediate transcription film 31, the adhesive force of the whole face of the intermediate transcription film 31 may be diminished. Though the adhesive force is diminished, in reality, slight adhesive characteristics remain. In addition, the minute tile-shaped device 113 is extremely thin and light. Therefore, the minute tile-shaped device 113 is held on the intermediate transcription film 31.

### Step 10

This step is not shown in the figure. In this step, by providing heat treatment or the like, the minute tile-shaped device 113 is definitely jointed to the final substrate 115. An electrode of the minute tile-shaped device 113 is electrically connected to a circuit on the final substrate 115 by a wiring, and one LSI chip is completed.

### Step 11

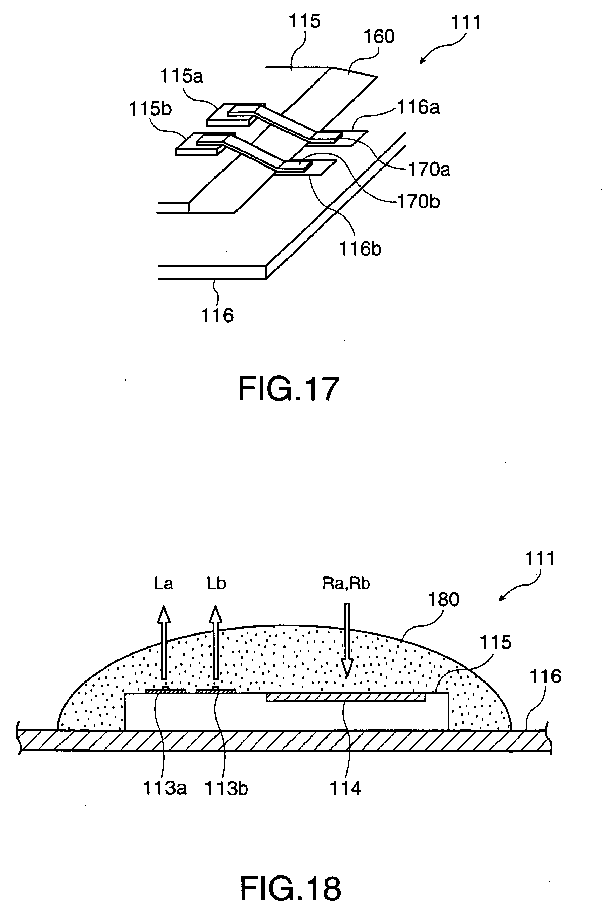

Fig. 17 is a schematic cross section showing step 11 of the manufacturing method of the optical sensor 111.

In this step, the final substrate manufactured by the foregoing method, that is, the integrated circuit board 115 is mounted on the printed wiring board 116. The integrated circuit board 115 is mounted on the printed wiring board 116 in such a manner that the side on which the minute tile-shaped device 113 (light emitting devices 113a and 113b) is located upward.

Next, electrodes 115a and 115b of the integrated circuit board 115 are electrically connected to printed wirings 116a and 116b of the printed wiring board 116 through wirings 170a and 170b. As a connection method thereof, for example, the method described in JP-A-2004-281539 can be used. That is, a slope 160 is formed from an insulating material such as a resin to cover a step on the side face of the mounted integrated circuit board 115, the wirings 170a and 170b are provided on the surface of the slope 160, and thereby the integrated circuit board 115 and the printed wiring substrate 116 can be electrically connected. In this case, the height of the wirings 170a and 170b becomes smaller than in the case that connection is made by wire bonding, that is, can be almost the same as the height of the integrated circuit board 115. However, when the height of the wirings 170a and 170b would not matter, connection may be made by wire bonding.

The wirings 170a and 170b are preferably formed by droplet discharge method for forming a metal pattern by discharging droplets containing a metal from an unshown inkjet head (droplet discharge head). Thereby, compared to the case of forming a metal pattern by photolithography, etching and the like, component materials do not much go to waste and it becomes easy to address design change or the like, and thus the manufacturing cost can be reduced.

The surface of the integrated circuit board 115 is desirably protected from mechanical impulse by a resin or the like. Fig. 18 is a view showing a state that the integrated circuit board 115 is molded by a resin 180. As the resin 180, a material having sufficient transmission characteristics for the reference light La, Lb, Ra, and Rb is desirably used. Thereby, the light emitting devices 113a and 113b, the light receiving device 114 and the like can be protected without affecting light detection.

Meanwhile, the printed wiring board 116 is desirably opaque for the reference light La, Lb, Ra, and Rb (for example, transmittance of 10% or less). Otherwise, a light shielding member is desirably provided for the printed wiring board 116 on the opposite face of the integrated circuit board 115. Thereby, noise due to stray light can be inhibited.

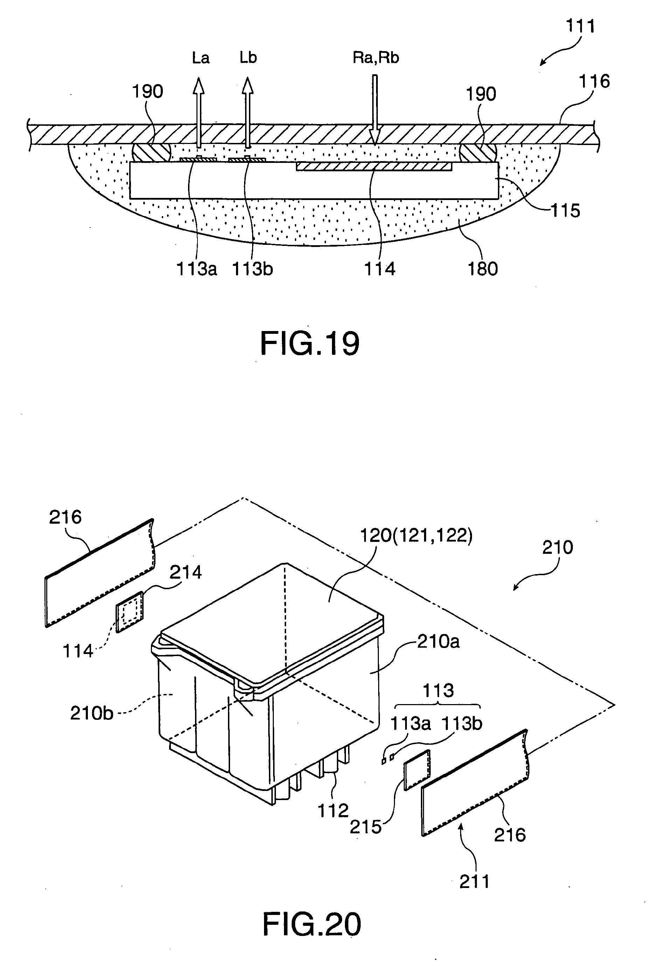

Fig. 19 is a schematic cross section showing another example of step 11.

In Fig. 19, the integrated circuit board 115 is flip-chip mounted on the printed wiring board 116. That is, the face of the integrated circuit board 115 on which the light emitting devices 113a and 113b, and the light receiving device 114 are provided is arranged oppositely to the printed wiring board 116. A bump 190 which is a connection member provided on the integrated circuit board 115 is mounted on the printed wiring of the printed wiring board 116 or a pad thereof. Thereby, the integrated circuit board 115 is electrically connected to the printed wiring board 116. The method has an advantage that productivity is high, since fixing the integrated circuit board 115 and electrical connection thereof can be performed concurrently.

In the foregoing method, the reference light is radiated and is received through the printed wiring board 116. Therefore, for the printed wiring board 116, a material with sufficient transmittance (for example, 50% or more) for the reflectance light La, Lb, Ra, and Rb should be used. Otherwise, a through hole for transmitting light may be provided in a radiation section and a receiving section of the reference light (that is, sections opposed to the light emitting devices 113a and 113b, and the light receiving device 114).

In the foregoing method, it is desirable that the clearance between the integrated circuit board 115 and the printed wiring board 116 is filled with and coated with the resin 180, so that the light emitting devices 113a and 113b and the light receiving device 114 can be protected.

Consequently, the optical sensor 111 is completed. The optical sensor 111 is jointed to the outer wall of the ink cartridge 110 with the resin 119 or the like shown in Fig. 3. The mounting position of the optical sensor 111 is set to an appropriate position by considering easiness of detecting light, easiness of detecting the remaining amount of ink or the like.

As described above, in the optical sensor 111 of this embodiment, the identification markers as an identification indicator are contained in the ink 120, which is the subject, the identification markers are optically identified, and thereby the type or the like of the ink 120 is identified. The light absorption characteristics of the identification markers can be voluntarily controlled by the type and the amount (density) of the identification markers. Therefore, compared to the existing method of identifying the type or the like of the ink 120 by slight differences of light absorption characteristics of the ink itself, precise identification is enabled.

In particular, in this embodiment, as an identification marker, the plurality of identification markers 121 and 122 which absorb light in a wavelength different from each other are contained, and the reference light La and Lb corresponding thereto is radiated to the identification markers 121 and 122. In addition, the combination of the plurality of identification markers 121 and 122 (that is, the type of the ink 120) is identified based on the light absorbance ratio between the plurality of identification markers 121 and 122 in relation to the respectively corresponding reference light La, Lb, or the density ratio between the plurality of identification markers 121 and 122 calculated therefrom. Therefore, compared to the case that the ink 120 is identified by using a single identification marker and single reference light, more accurate identification is enabled. That is, when identification is made by using single reference light, light amount change between the reference light before being transmitted through the ink 120 and the reference light after being transmitted through the ink 120 is detected. In this case, the transmitted light amount may be largely changed due to absorption by the ink cartridge 110 accommodating the ink 120, and therefore accurate identification may be difficult. Meanwhile, when identification is made based on the light absorbance ratio between the plurality of reference light La and Lb (ratio between transmitted light amounts), absorption by the ink cartridge 110 occurs at the similar ratio for all the reference light, and therefore a detection error as a light absorbance ratio is not much large. Therefore, when the light absorbance ratio between the identification markers 121 and 122 (that is, density ratio between the identification markers 121 and 122) is appropriately adjusted, the type or the like of the ink 120 can be accurately identified with almost no detection error.

Further, in this embodiment, the light emitting devices 113a and 113b are jointed to the integrated circuit board 115 by the transcription technology. Therefore, the integrated circuit board 115 with a compact structure and a high light emitting function can be realized.

Further, the light emitting device fabricated by the transcription technology is extremely thin, being several ten µm or less thick. Therefore, not only the light on the top face side radiated as the reference light La and Lb, but also the light on the bottom face side radiated to the compound semiconductor layer side can be extracted outside. That is, when the compound semiconductor substrate 10 formed with the light emitting section is directly utilized as the light emitting devices 113a and 113b without using a transcription technology, a thick compound semiconductor layer (compound semiconductor substrate 10) exists under the active layer, and therefore even when light is radiated from the active layer to the integrated circuit board 115 side (compound semiconductor layer 10 side), the light is mostly absorbed by the compound semiconductor layer 10, and is not able to be extracted outside. Therefore, in this case, when light radiated from the light emitting devices 113a and 113b is monitored and provided with Auto Power Control (APC), a special light receiving optical system for monitoring which performs, for example, reflecting part of the reference light La and Lb radiated to the top face side (opposite side of the integrated circuit board 115) becomes necessary.

Meanwhile, in the case of the light emitting devices 113a and 113b fabricated by the transcription technology, the light emitting devices 113a and 113b are formed by exfoliating the surface section of the compound semiconductor substrate layer 10. Therefore, the compound semiconductor layer 12 becomes extremely thin, and the light Ma and Mb radiated to the integrated circuit board 115 side is hardly absorbed by the compound semiconductor layer 12 and can be extracted outside. Therefore, when the light receiving devices for monitoring 118a and 118b which monitor such light are provided on the integrated circuit board 115 side, APC can be easily performed without providing a special light receiving optical system. Furthermore, such light Ma and Mb is useless light which should be originally absorbed by the compound semiconductor substrate 10. Therefore, by utilizing the light Ma and Mb as monitor light, light can be utilized effectively.

Further in this embodiment, the plurality of light emitting devices 113a and 113b radiate the reference light La and Lb to the ink 120 in the time-sharing manner. Therefore, the light receiving device 114 can be common to the light emitting devices 113a and 113b, and thus the optical sensor 111 can be downsized.

In this embodiment, descriptions have been given of the case that the optical sensor 111 is mounted on the outer wall of the ink cartridge 110. However, the mounting position of the optical sensor 111 is not limited thereto. For example, the optical sensor 111 can be mounted on the section of the cartridge holder to which the outer wall of the ink cartridge is contacted. The optical sensor 111 can be mounted on the ink cartridge mounting section of the carriage 101 to which the outer wall of the ink cartridge is contacted. The optical sensor 111 can be mounted on the section in the middle of the ink flow path from the ink cartridge 110 to the head 106. The optical sensor 111 can be built in the head 106.

### Second Embodiment

Fig. 20 is an exploded perspective view showing a main section of an ink cartridge 210 including an optical sensor 211 according to a second embodiment of the invention. For components similar to in the first embodiment will be affixed with the same referential characters, and detailed descriptions thereof will be omitted.

As shown in Fig. 20, the optical sensor 211 has the light emitting devices 113a and 113b for radiating reference light to ink inside the ink cartridge 110, the light receiving device 114 for receiving the reference light transmitted through the ink inside the ink cartridge 110, a first integrated circuit board 215 electrically connected to the light emitting devices 113a and 113b, a second integrated circuit board 214 electrically connected to the light receiving device 114, and a printed wiring board 216 electrically connected to the first integrated circuit board 215 and the second integrated circuit board 214.

The first integrated circuit board 215 is provided with the first current control circuit 130a and the second current control circuit 130b shown in Fig. 6. The second integrated circuit board 214 is provided with the amplification circuit 140 shown in Fig. 6. Functions of the first current control circuit 130a, the second current control circuit 130b, and the amplification circuit 140 are the same as of the first embodiment.

In the optical sensor 211, the light emitting devices 113a and 113b and the light receiving device 114 are provided separately on the different integrated circuit boards 215 and 214. The light emitting devices 113a and 113b and the light receiving device 114 are respectively arranged on an opposite faces 210a and 210b of the outer wall of the ink cartridge in such a manner that the light axis of the light emitting devices 113a and 113b corresponds with the light axis of the light receiving device 114. The printed wiring substrate 216 mounted with the integrated circuit board 214 and the integrated circuit board 215 is wound around the side face of the ink cartridge 210 in such a manner that the printed wiring board 216 covers an outer wall 210a and an outer wall 210b.

In Fig. 20, the printed wiring board 216 is one printed wiring board mounted with both the first integrated circuit board 215 and the second integrated circuit board 214. However, it is possible to provide two printed wiring boards, that is, a first printed wiring board mounted with the first integrated circuit board 215 and a second printed wiring board mounted with the second integrated circuit board 214.

In the optical sensor 211, a plurality of reference light in a peak wavelength different from each other which is respectively radiated from the light emitting device 113a and the light emitting device 113b is radiated to the ink 120 inside the ink cartridge 210 through the outer wall of the ink cartridge 210, each intensity of each reference light transmitted through the ink 120 (that is, light absorbance) is compared, and thereby the type or the like of the ink 120 is identified. In the above structure, the reference light radiated from the light emitting devices 113a and 113b is guided to the light receiving device 114 via the outer wall 210a of the ink cartridge 210, the ink 120, and the outer wall 210b.

As above, in the optical sensor 211 of this embodiment, the light emitting devices 113a and 113b and the light receiving device 114 are arranged oppositely to each other on the opposite faces of the ink cartridge 210. Therefore, even when the light reflector which is used in the first embodiment is not provided for the ink cartridge 210, light absorption and transmission of the ink 120 can be measured. It means that the optical sensor of the embodiment of the invention can be applied to an ink cartridge which is not fabricated specially for the optical sensor of the embodiment of the invention. Therefore, for example, when an ink cartridge made by other manufacturer is wrongly mounted and ink with constituents different from of the ink which should be originally used (for example, ink which may cause clogging in the nozzle hole) is used, an alert can be issued to users to note such a state, and users can be prompted to take a measure to use correct ink.

While the embodiments according to the invention have been described with reference to the accompanied drawings, it is needless to say that the invention is not limited to the above embodiments. The shapes, combinations and the like of each component member described in the foregoing embodiments are illustrative only, and various modifications may be made based on design requirement and the like within the scope of the invention.

For example, in the above embodiments, the case in which the optical sensor of the embodiment of the invention is applied to the ink cartridge for accommodating ink used for printing on the recording sheet 109 has been described. However, the optical sensor of the embodiment of the invention is not limited thereto. For example, the optical sensor of the embodiment of the invention can be widely applied to ink cartridges such as an ink cartridge for accommodating ink for forming a wiring in the case that a metal wiring is manufactured by inkjet method, or an ink cartridge for accommodating ink for forming a device such as an organic EL material and a color filter material. Further, while in the above embodiments, the case that the optical sensor of the embodiment of the invention is applied to a sensor for identifying ink has been described, the optical sensor of the embodiment of the invention is not limited to the purpose for identifying ink but can be widely utilized as a sensor for identifying various subjects.

## Claims

1. An optical sensor for identifying a subject, comprising:
a light absorption member with light absorption characteristics adjusted independently from the subject so that the optical sensor identifies the subject by optically identifying the light absorption member ;
a light emitting device for radiating reference light having a peak wavelength in an absorption wavelength region of the light absorption member to the subject;
a light receiving device for receiving the reference light transmitted through the subject; and
an integrated circuit board provided with the light emitting device and the light receiving device on a substrate face.

2. The optical sensor according to Claim 1, wherein a light absorption peak wavelength of the light absorption member exists in the infrared region.

3. The optical sensor according to Claim 1, wherein as the light absorption member, a plurality of light absorption members for absorbing light in a wavelength different from each other are provided,
as the light emitting device, a plurality of light emitting devices having each peak wavelength corresponding to a light absorption peak wavelength of the plurality of light absorption members are provided, and
the plurality of light absorption members are identified based on a light absorbance ratio between the plurality of light absorption members in relation to the reference light or a density ratio between the plurality of light absorption members calculated therefrom, and the subject is identified based on a result of the identification.

4. The optical sensor according to Claim 3, wherein the light emitting device is jointed to the integrated circuit board by a transcription technology.

5. The optical sensor according to Claim 4, wherein the light emitting device is made of one of a vertical cavity surface emitting laser and a light emitting diode.

6. The optical sensor according to Claim 4, wherein a light receiving device for monitoring which monitors the reference light radiated from the light emitting device to the integrated circuit board side in a section of the integrated circuit board where the light emitting device is arranged.

7. The optical sensor according to Claim 6, wherein a current control circuit for controlling a light emitting amount of the light emitting device based on a light amount of light received by the light receiving device for monitoring is provided on the integrated circuit board.

8. The optical sensor according to Claim 6, wherein an amplification circuit for amplifying a signal of light received by the light receiving device for monitoring is provided on the integrated circuit board.

9. The optical sensor according to Claim 3, wherein the plurality of light emitting devices radiate the reference light to the subject in the time sharing manner.

10. The optical sensor according to Claim 9, wherein a memory for storing a transmitted light amount of the reference light received by the light receiving device is provided on the integrated circuit board.

11. The optical sensor according to Claim 3, wherein the light receiving device is directly formed on the integrated circuit board by a semiconductor film forming technology.

12. The optical sensor according to any of the preceding claims, wherein the integrated circuit board is mounted on a printed wiring insulating substrate.

13. The optical sensor according to any of the preceding claims, wherein the light emitting device or the light receiving device is sealed by a resin which transmits the reference light.

14. An ink cartridge comprising:
the optical sensor according to Claim 1, wherein the optical sensor identifies ink accommodated in the ink cartridge as the subject.

15. The ink cartridge according to Claim 14, wherein the ink cartridge is made of a member which transmits the reference light radiated from the light emitting device, and the optical sensor is mounted on an outer wall of the ink cartridge.

16. The ink cartridge according to Claim 15, wherein a resin having a refractive index equal to of the outer wall is filled between the outer wall of the ink cartridge and at least one of the light emitting device and the light receiving device.

17. An inkjet apparatus comprising:
one of the optical sensor according to Claim 1 and the ink cartridge according to Claim 14, wherein the optical sensor identifies ink accommodated in the ink cartridge as the subject.
